(19) Europäisches Patentamt
European Patent Office
Office européen des brevets

(11) **EP 1 122 791 B1**

(12) **EUROPÄISCHE PATENTSCHRIFT**

(45) Veröffentlichungstag und Bekanntmachung des Hinweises auf die Patenterteilung:
**08.08.2007  Patentblatt 2007/32**

(51) Int Cl.:
*H01L 27/146* [(2006.01)]     *H01L 31/0232* [(2006.01)]

(21) Anmeldenummer: **01101896.7**

(22) Anmeldetag: **27.01.2001**

(54) **An die Krümmung der Fokalebene angepasstes optoelektronisches Bildaufnahmesystem und desssen Herstellungsverfahren**

Optoelctronic imaging system adapted to curvature focal plane and method of fabrication

Système d'imagerie opto-électronique adapté à la curvature de plan focal et méthode de procédé.

(84) Benannte Vertragsstaaten:
**AT BE CH CY DE DK ES FI FR GB GR IE IT LI LU MC NL PT SE TR**

(30) Priorität: **04.02.2000  DE 10004891**

(43) Veröffentlichungstag der Anmeldung:
**08.08.2001  Patentblatt 2001/32**

(73) Patentinhaber: **Astrium GmbH**
**81663 München (DE)**

(72) Erfinder:
• **Ansorge, Dr. Frank**
**81245 München (DE)**
• **Craubner, Siegfried**
**82234 Wessling (DE)**
• **Feil, Michael**
**81475 München (DE)**
• **Platz, Dr. Willi**
**80992 München (DE)**
• **Riedel, Dr. Helmut**
**82256 Fürstenfeldbruck (DE)**

(74) Vertreter: **Ulrich, Thomas**
**EADS Deutschland GmbH,**
**LG-PM - Patente**
**81663 München (DE)**

(56) Entgegenhaltungen:
**EP-A- 0 642 177          WO-A-98/02921**
**US-A- 4 825 062          US-A- 5 037 190**
**US-A- 5 336 879          US-A- 6 002 163**

## Beschreibung

Die vorliegende Erfindung betrifft eine Vorrichtung für optoelektronische Bildaufnahmesysteme gemäß der Oberbegriffe der Patentansprüche 1 und 2 und ein Verfahren zur Herstellung einer Fokalfläche gemäß dem Oberbegriff von Patentanspruch 10.

Optoelektronische Bildaufnahmesysteme werden z. B. im Bereich der Raumfahrt, zur Erdbeobachtung, bei Aufklärungssystemen oder in der Fahrzeugtechnik zur Erkennung von Hindernissen eingesetzt. Optoelektronische Bildaufnahmesysteme bestehen im Sensorkopf aus einer Frontoptik, beispielsweise einem Objektiv oder Teleskop, Detektoren in der Fokalebene und einer Elektronik. Die Frontoptiken, wie beispielsweise die bei Weltrauminstrumenten häufig eingesetzten Spiegelteleskope, haben dabei ein gekrümmtes Bildfeld bzw. eine gekrümmte Fokalebene. Die Detektortechnologie verlangt jedoch einen ebenen Aufbau. Um ebene Detektorflächen in der Fokalebene anbringen zu können, müssen deshalb sogenannte Feldkorrektoren bzw. field-flattener den Teleskopen bzw. Optiken optisch nachgeschaltet werden, um die Bildfläche zu ebnen. Die Feldkorrektoren bestehen im Allgemeinen aus Linsen-Baugruppen, die meistens nur über einen begrenzten Bereich des Sehfeldes eine Korrektur des Bildfeldes bewirken können.

Zur Veranschaulichung zeigt Figur 4 ein bekanntes Cassegrain-System, das als Spiegelteleskop für Weltrauminstrumente verwendet werden kann. Figur 5 zeigt die gekrümmte Fokalfläche eines Konkavspiegels. Figur 6 zeigt ein Quasi-Ritchey-Chretien Booster-System mit einem bekannten Feldkorrektor bzw. seinem Strahlverlauf.

Bei vielen Anwendungen ist jedoch ein weites Sehfeld notwendig, beispielsweise um einen möglichst breiten Abtaststreifen zu erhalten. Insbesondere in einem abtastenden Pushbroom-Instrument verlangt dies in gleichem Maße die Erweiterung des Teleskop-Sehfeldes. Für ein geometrisch hoch auflösendes Raumfahrt-Instrument kommen aus Festigkeitsgründen, insbesondere um die Startlasten zu überstehen, in erster Linie Spiegelteleskope in Frage. Weiterhin ist in vielen Fällen eine spektral breitbandige Empfindlichkeit erforderlich.

Die Detektoren in der Fokalebene bilden das Herzstück optoelektronischer Bildaufnahmesysteme. Dabei werden z. B. die bekannten CCD-Detektoren verwendet, oder auch die bekannten CMOS-Detektoren mit aktiver Pixeltechnik. Diese Detektoren haben eine integrierte Ausleseelektronik und können in einem Herstellungsprozess gefertigt werden.

Im Bereich der Fahrzeugtechnik werden zur Erkennung von Hindernissen Kameras mit großem Sehfeld bzw. Panoramakameras benötigt. Diese erfordern jedoch eine komplizierte Optik um ein großes Sehfeld zu erreichen und Verzerrungen zu reduzieren. Dementsprechend hoch ist der Preis für eine Kamera bzw. ein Bildaufnahmesystem für derartige Anwendungen.

Um eine hohe Abbildungsqualität zu erreichen, sind auch sehr enge thermo-mechanische Toleranzen notwendig. Die Feldkorrektoren schränken häufig den spektralen Übertragungsbereich ein, was z. B. durch einen engen Transmissionsbereich von eingesetzten Linsen-Gläsern bedingt wird.

Insgesamt ergeben sich also bei den bekannten optoelektronischen Bildaufnahmesystemen bzw. Detektor-Anordnungen erhebliche Nachteile, wie z.B die Einschränkung des Sehfeldes und die Begrenzung spektraler Übertragungseigenschaften der Teleskope, ein komplexer Aufbau mit Feldkorrektoren zur Erzeugung planarer Bildebenen, komplizierte und aufwendige Frontoptiken und hohe Kosten.

Die Internationale Anmeldung WO 98/02921 beschreibt flexible, integrierte Dünnfilmschaltungen für verschiedenartige Anwendungen, wie beispielsweise Displays, Detektoren, Multichip-Module, PCMSIA-Karten und Smart-Kart-Devices. Die WO 98/02921 betrifft integrierte Schaltkreise. Um für eine große Anzahl von Anwendungen brauchbar zu sein werden integrierte Schaltkreise so hergestellt, dass sie hochflexibel und ultra-dünn sind. Die beschriebenen flexiblen Schaltkreise haben Großenordnungen von mehreren Zentimetern Oberfläche und gleichzeitig eine Dicke von wenigen Microns. Die Schaltkreise werden unter Verwendung von Transfer-Techniken hergestellt, welche die Entfernung von VLSI-Schaltkreisen von Silikon-Wafern und das Aufbringen der Schaltkreise auf anwendungsspezifischen Substraten umfassen.

Die US 4,825,062 betrifft ein erweiterbares Phased-Array-Spiegel-System mit großer Apertur. Das beschriebene System umfasst eine Vielzahl von Spiegelsegmenten, welche so konfiguriert sind, dass sie gemeinsam einen eingehenden elektromagnetischen Strahl empfangen können. In Antwort auf Signale von einem Sensor, welcher eine Verzerrung der Wellenfront im Strahl anzeigt, verrückt eine Steuerungseinrichtung eine Vielzahl von Segmentaktuatoren, um die Spiegelsegmente so zu konfigurieren, um einen ausgehenden elektromagnetischen Strahl mit konjugierter Phase zu erzeugen.

Es ist die Aufgabe der vorliegenden Erfindung die o.g. Nachteile zu überwinden, optoelektronische Bildaufnahmesysteme zu vereinfachen und weitere Sehfelder zu ermöglichen.

Diese Aufgabe wird gelöst durch Vorrichtungen für optoelektronische Bildaufnahmesysteme gemäß Patentansprüchen 1 und 2 und das Verfahren zur Herstellung einer Fokalfläche gemäß Patentanspruch 10. Weitere vorteilhafte Merkmale, Aspekte und Details der Erfindung ergeben sich aus den abhängigen Ansprüchen, der Beschreibung und den Zeichnungen.

Gemäß der vorliegenden Erfindung wird eine Vorrichtung für optoelektronische Bildaufnahmesysteme geschaffen, mit einer Anordnung von Detektoren zur Bildaufnahme und einem Detektorträger zum Halten der Detektoren, wobei die Detektoren jeweils aus mindestens einem Silizium-Element hergestellt sind und wobei die Detektoren eine Krümmung zur Aufnahme eines gekrümmten Bildfelds aufweisen und wobei die Detektoren flexibel ausgestaltet sind, und wobei das Silizium-Element gedünnt ist und mit einem flexiblen Trägersubstrat verbunden ist, wobei durch ein Temperatur-Kontrollsystem, welches so ausgelegt ist, dass die Temperaturverteilung im Detektorträger möglichst gleichmäßig ist, und wobei das Temperatur-Kontrollsystem Kanäle im Detektorträger aufweist, welche in Gegenstromrichtung verlaufen.

Gemäß der vorliegenden Erfindung wird ferner eine Vorrichtung für optoelektronische Bildaufnahmesysteme geschaffen, mit einer Anordnung von Detektoren zur Bildaufnahme, und einem Detektorträger zum Halten der Detektoren, wobei die Detektoren jeweils aus mindestens einem Silizium-Element hergestellt sind und wobei die Detektoren eine Krümmung zur Aufnahme eines gekrümmten Bildfelds aufweisen und wobei die Detektoren flexibel ausgestaltet sind, und wobei das Silizium-Element gedünnt ist und mit einem flexiblen Trägersubstrat verbunden ist, wobei durch ein Temperatur-Kontrollsystem, welches so ausgelegt ist, dass die Temperaturverteilung im Detektorträger möglichst gleichmäßig ist, und wobei der Detektorträger an Peltierelemente gekoppelt ist.

Dadurch wird die Empfindlichkeit gegenüber Temperaturschwankungen verringert, d.h. die Vorrichtung und damit ausgestattete Bildaufnahmesysteme werden thermo-mechanisch robuster.

Ferner werden Feldkorrektoren zur Erzeugung planarer Bildebenen überflüssig und somit die Frontoptiken der Bildaufnahmesysteme vereinfacht. Sie können thermo-mechanisch robuster ausgestaltet werden. Weitere Sehfelder werden möglich, die z.B. bei 15° im Fall von Schmidt-Teleskopen liegen können, da die Feldkorrektoren entfallen, die ansonsten das Sehfeld begrenzen. Darüber hinaus bleiben breitbandige spektrale Übertragungseigenschaften der Teleskope bzw. Frontoptiken erhalten.

Ferner wird eine Vorrichtung offenbart, wobei darüber hinaus der Detektorträger an Peltierelemente gekoppelt ist.

Ferner wird eine Vorrichtung offenbart, wobei darüber hinaus die Detektoren aus dünnen Silizium-Wafern hergestellt sind und gekrümmt in einer Fokalfläche angeordnet sind.

Ferner wird eine Vorrichtung offenbart, wobei darüber hinaus die Detektoren mittels eines Hilfsträgers hergestellt sind, der zum Dünnen des mindestens einen Silizium-Elements mit dem Silizium-Element verbunden ist und nach dem Dünnen entfernbar ist.

Dadurch kann das Silizium-Element bzw. der Detektor besonders dünn und flexibel ausgestaltet werden, so dass entsprechend große Krümmungen erreicht werden. Es ergibt sich insbesondere eine besonders große Flexibilität bzw. Verbiegbarkeit der Detektoren und der Fokalfläche.

Vorteilhafterweise hat das Silizium-Element eine Dicke im Bereich von weniger als $50\mu$m, bevorzugt weniger als $20\mu$m, insbesondere ca. 10 bis 20 $\mu$m. Das Längenzu Breitenverhältnis des Silizium-Elements kann im Bereich von ca. 20 bis 60, bevorzugt bei ca. 40 liegen. Vorteilhafterweise ist es größer als 20.

Ferner wird eine Vorrichtung offenbart, wobei darüber hinaus die Detektoren CMOS-Zeilendetektoren sind.

Dadurch können auf kostengünstige Weise flexible bzw. gekrümmte oder krümmbare Detektoren mit integrierter Ausleseelektronik in CMOS-Technologie gefertigt werden.

Ferner wird eine Vorrichtung offenbart, wobei darüber hinaus eine Aktorik zur variablen Krümmung der Detektoren vorhanden ist. Ferner wird eine Vorrichtung offenbart, wobei darüber hinaus eine Aktorik zur variablen Krümmung der Fokalfläche vorhanden ist. Dadurch wird eine aktive Regelung der flexiblen, gekrümmten Fokalebene möglich. Neue Teleskop-Konzepte werden realisierbar, die verbesserte optische Eigenschaften aufweisen bzw. vereinfacht oder mit weniger Bauteilen ausgestaltet werden können.

Gemäß der vorliegenden Erfindung wird ein Verfahren zur Herstellung einer Fokalfläche für optoelektronische Bildaufnahmesysteme angegeben, bei dem ein gekrümmter Detektorträger mit einer Detektor-Anordnung zur Bildaufnahme versehen wird, wobei zur Ausgestaltung flexibler Detektoren jeweils mindestens ein Silizium-Element gedünnt und mit einem flexiblen Trägersubstrat verbunden wird, wobei die flexiblen Detektoren an die Krümmung des Detektorträgers angepasst werden oder anpassbar sind und ferner ein Temperatur-Kontrollsystem im Detektorträger eingebracht wird, welches die Temperaturverteilung im Detektorträger möglichst gleichmäßig hält.

Durch dieses Verfahren wird es möglich, Fokalflächen zu schaffen, die beim Einsatz in optoelektronischen Bildaufnahmesystemen keine Feldkorrektoren benötigen. Das Verfahren kann kostengünstig durchgeführt werden, wobei Techniken der Mikromechanik eingesetzt werden können. Das Verfahren ist die Grundlage zur Schaffung von optoelektronischen Bildaufnahmesystemen bzw. Fokalflächen, mit denen größere Sehfelder, verbesserte optische Eigenschaften und eine einfache Konstruktion ermöglicht werden. Weiterhin können die optischen Elemente, wie Linsen, Teleskope, usw., vereinfacht und in ihrem Gewicht reduziert werden.

Ferner wird ein Verfahren offenbar, wobei darüber hinaus das Silizium-Element zum Dünnen mit einem Hilfsträger verbunden wird.

Ferner wird ein Verfahren offenbart, wobei darüber hinaus das Silizium-Element zum Dünnen mit einem Hilfsträger verbunden wird, wobei der Hilfsträger nach dem Dünnen entfernt wird oder entfernbar ist.

Ferner wird ein Verfahren offenbar, wobei darüber hinaus das Dünnen durch Abtragen mittels Schleifen, Ätzen, Spin-Ätzen, chemisch-mechanisches Polieren oder eine Kombination davon erfolgt.

Ferner wird ein Verfahren offenbart, wobei darüber hinaus das Silizium-Element zunächst als Wafer vorliegt und vor dem Verbinden mit dem Trägersubstrat in Chips vereinzelt wird.

Ferner wird ein Verfahren offenbart, wobei darüber hinaus das Silizium-Element durch isoplanare Kontaktierung mit elektrischen Kontakten versehen wird.

Ferner wird ein Verfahren offenbart, wobei darüber hinaus das Silizium-Element mit einer lichtdurchlässigen Abdeckung versehen wird, wodurch die Bruchempfindlichkeit deutlich herabgesetzt wird.

Die Erfindung wird nachfolgend beispielhaft anhand der Figuren beschrieben. Es zeigen:

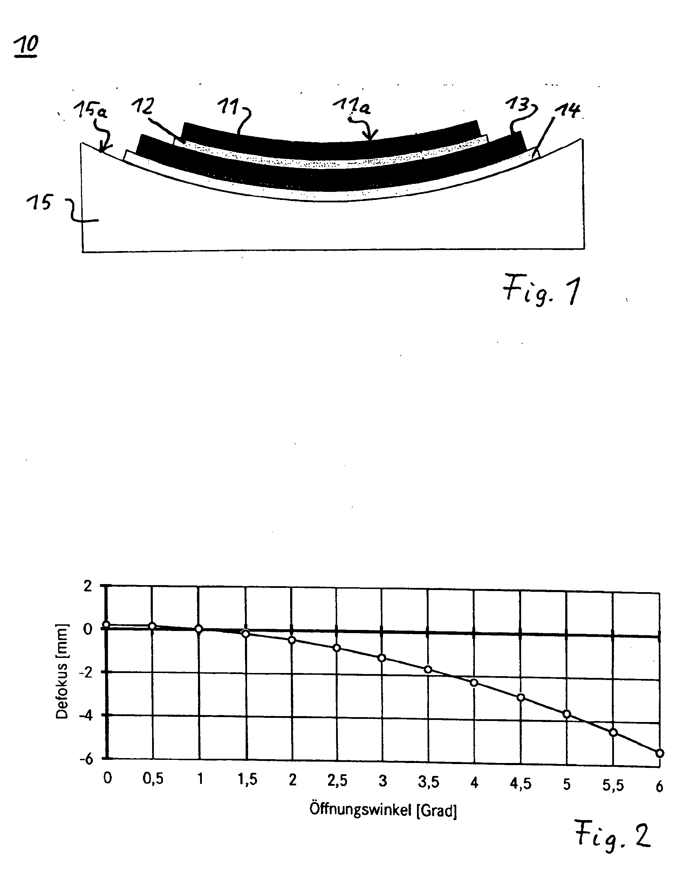

Fig. 1        eine schematische Schnittansicht einer Fokalfläche als bevorzugte Ausführungsform der Erfindung;
Fig. 2        die Krümmung eines Bildfeldes, an die die Fokalfläche angepasst ist

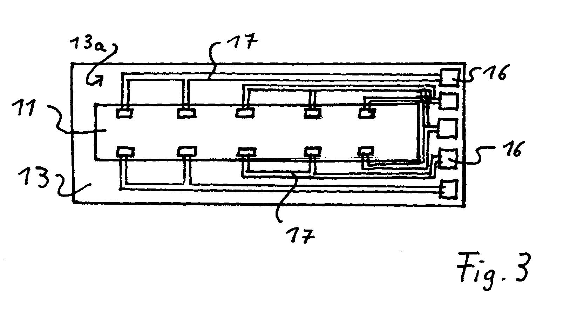

Fig. 3        eine Draufsicht auf ein erfindungsgemäßes Detektormodul bzw. - element

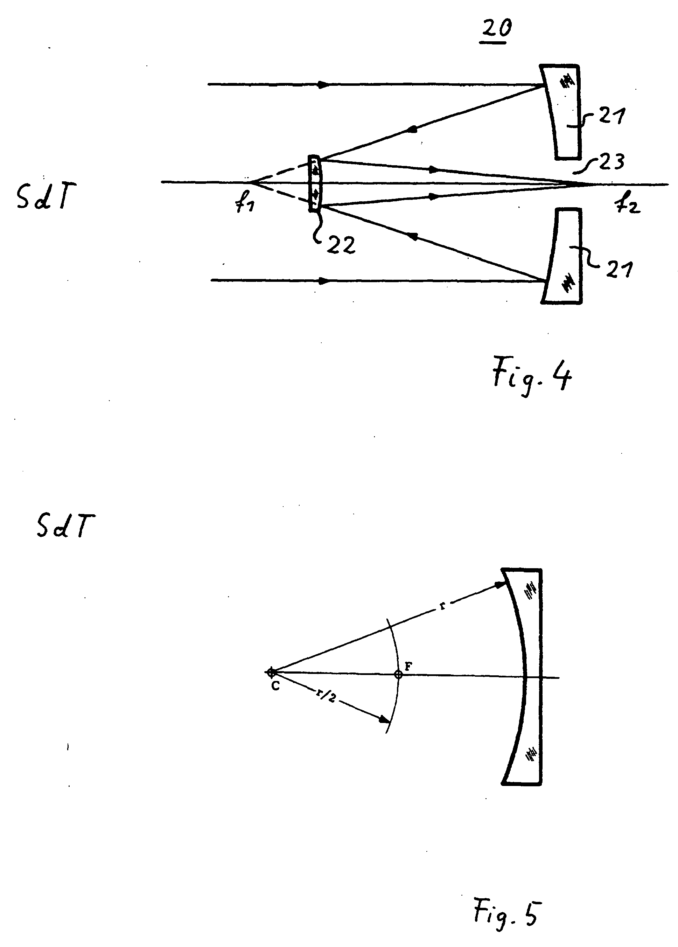

Fig. 4        ein bekanntes Cassegrain-System;
Fig. 5        eine gekrümmte Fokalfläche eines Konkavspiegels;

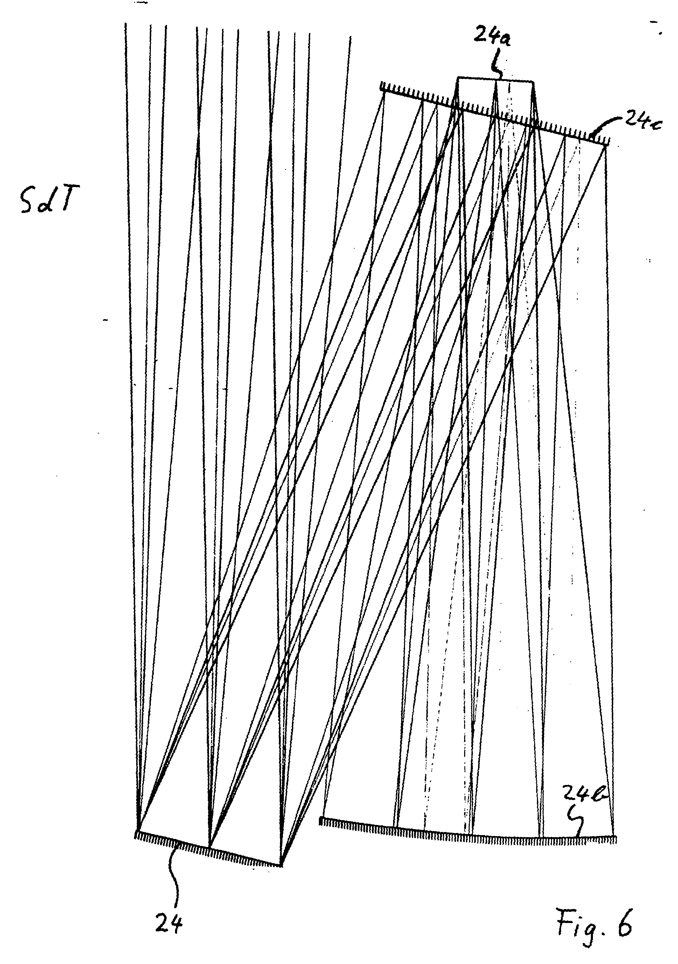

Fig. 6        den Strahlverlauf in einem bekannten Schmidt-Teleskop mit reflektivem Korrektor;
Fig. 7        einen Längsschnitt durch eine Fokalfläche mit einem Temperatur-Kontrollsystem gemäß einer weiteren bevorzugten Ausführungsform der Erfindung;

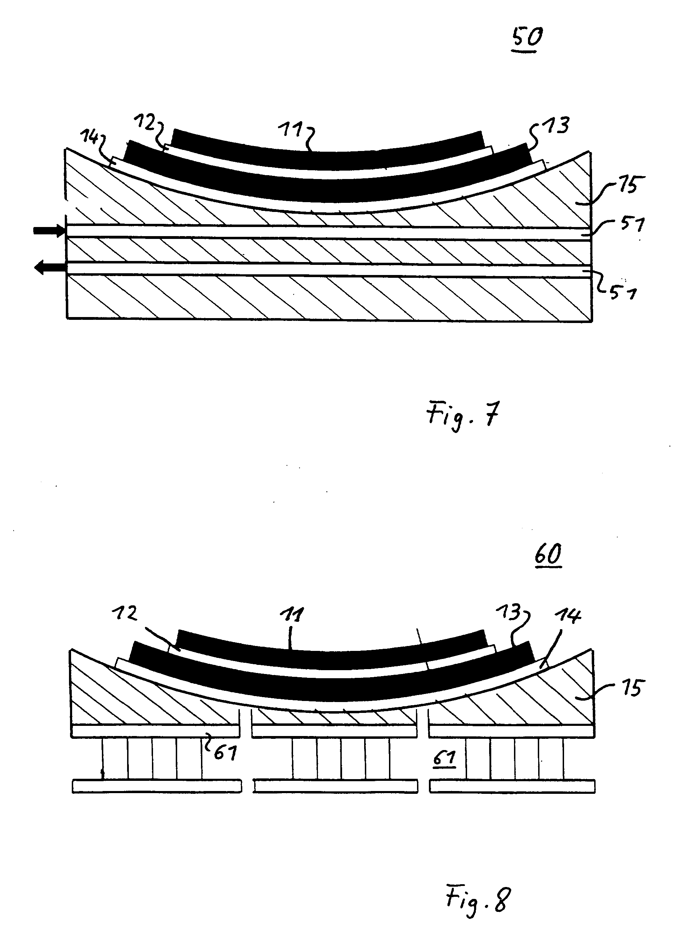

Fig. 8        einen Längsschnitt durch eine Fokalfläche mit einem Temperaturkontrollsystem gemäß einer anderen bevorzugten Ausführungsform der Erfindung;

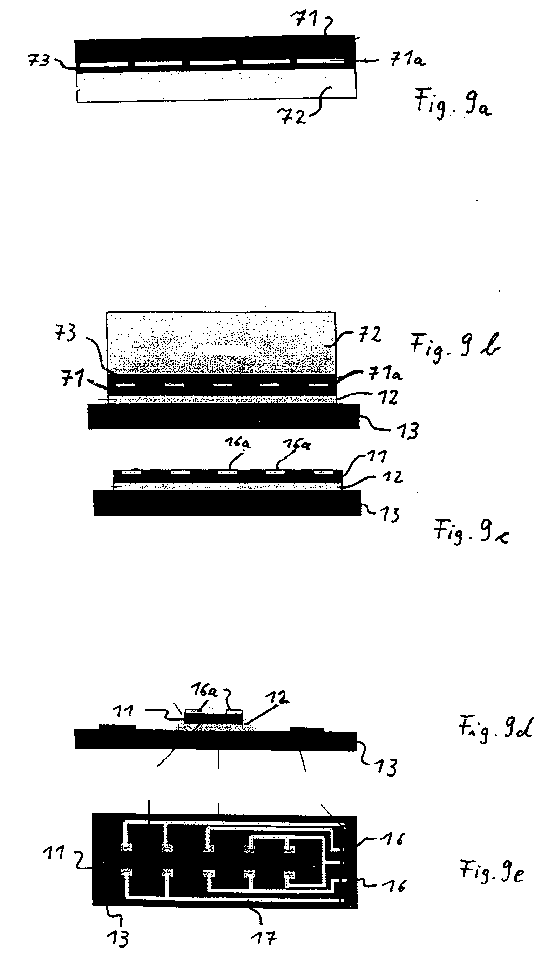

Fig. 9a bis g    verschiedene Schritte zur Herstellung der erfindungsgemäßen Fokalfläche; und

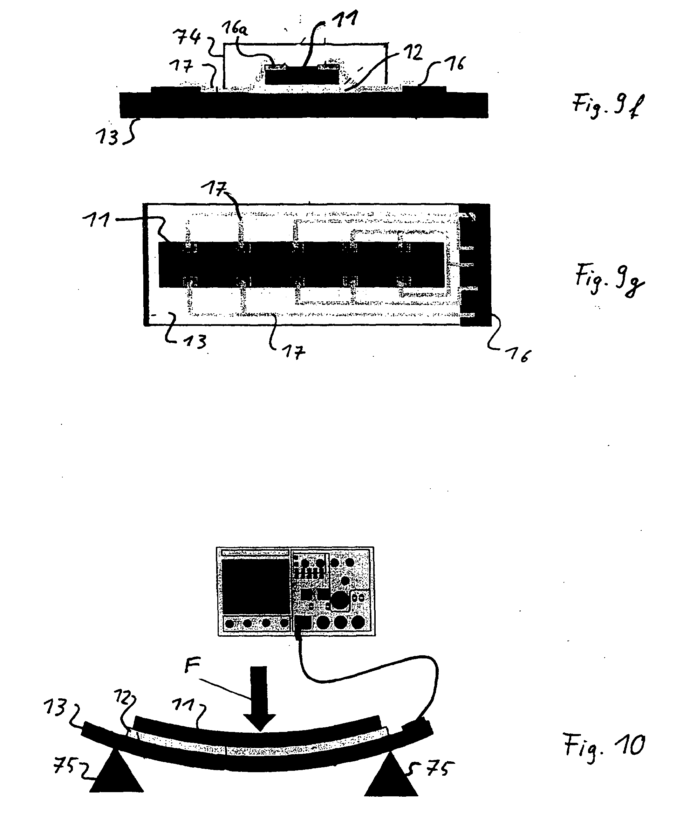

Fig. 10       eine erfindungsgemäße Fokalfläche mit variablem Krümmungsradius.

Eine erste bevorzugte Ausführungsform der Erfindung wird nachfolgend anhand der Figur 1 beschrieben. Figur 1 zeigt dabei schematisch einen Schnitt durch einen Teil einer Fokalfläche 10. Die Fokalfläche 10 umfasst einen oder mehrere Detektoren 11, wobei in der Abbildung nur ein Detektor 11 in Form eines Zeilensensors dargestellt ist. Der

Detektor 11 ist ein CMOS-Zeilendetektor mit einem relativ großen Längen- zu Breitenverhältnis, das im vorliegenden Fall ca. 40 beträgt. Er besteht aus einem Chip bzw. Silizium-Element, das über eine erste Verbindungsschicht 12 mit einem flexiblen Trägersubstrat 13 verbunden ist. Die erste Verbindungsschicht 12 ist dabei ein Kleberauftrag, der besonders dünn ausgestaltet ist und eine Dicke von weniger als $10\mu m$, bevorzugt ca. 1 bis $2\mu m$ hat. Das Trägersubstrat 13 ist aus einer flexiblen Folie gebildet, die eine Dicke von ca. 50 bis $100\mu m$ hat. Das flexible Trägersubstrat 13 mit dem darauf befindlichen Chip ist durch eine zweite Verbindungsschicht 14, die ebenfalls eine Kleberschicht ist, mit einem Detektorträger 15 verbunden. Der Detektorträger 15 bildet somit eine Fokalflächen-Rückplatte zum Tragen einer Vielzahl von Detektormodulen oderelementen mit Detektoren 11. An seiner Oberfläche 15a hat der Detektorträger 15 eine Krümmung, an die der Detektor 11 angepasst ist. D.h., der Detektor 11 ist ebenfalls gekrümmt bzw. flexibel. Durch die Krümmung an seiner Oberfläche 11 a ist der Detektor 11, zusammen mit weiteren auf dem Detektorträger 15 befindlichen Detektoren, zur Aufnahme eines gekrümmten Bildfeldes geeignet.

Der Grad der Fokalebenen-Krümmung ist von dem konkreten Anwendungsfall abhängig. Bei einem bekannten Weitwinkel-Teleskop bzw. einem typischen, reflektiven Schmidt-Teleskop in einem Bildaufnahmesystem kann z.B. als Apperturdurchmesser Do ein Wert von 20cm und als Brennweite f ein Wert von 1m angenommen werden. Das Öffnungsverhältnis F# beträgt damit: F# = f/Do = 5. In Abhängigkeit vom Bildwinkel lassen sich unterschiedliche Bildhöhen und der Defokus berechnen. Beispielsweise ergibt sich bei einem Bildwinkel von $\pm 3°$ eine Bildhöhe von 105,52mm. Die Höhenunterschiede bei $\pm 3°$ betragen gegenüber der Mitte -1,2mm, und bei $\pm 6°$ 5,35mm. Mit den erfindungsgemäßen Detektoren 11 bzw. der Fokalfläche 10 lassen sich die entsprechenden Krümmungen erreichen.

Die Krümmung der Fokalfläche 10 ist so ausgelegt, dass die Wellenfront senkrecht auf die Detektoren 11 bzw. auf die Detektoroberfläche 11 trifft. Dabei ergeben sich die notwendigen Toleranzen aus der Tiefenschärfe $\delta S$ unter Einhaltung der $\lambda/4$-Grenze aus der Formel:

$$\delta S = \frac{\pm \lambda}{2\, n\, \sin^2 U_m} \qquad\qquad\qquad (1)$$

wobei Um der Grenzstrahlwinkel am Bild und $\lambda$ die Wellenlänge ist.

Mit n=1, $\lambda$=0,65$\mu m$ und F# = 5 ergibt sich für die physikalische Tiefenschärfe $\delta S$ ein Wert von $\pm 32,5\mu m$. Bei der Herstellung der Fokalfläche 10 können Toleranzen im Bereich um ca. $\pm 30\mu m$ ohne weiteres eingehalten werden. Die Krümmung der Fokalfläche 10 gemäß der bevorzugten Ausführungsform ist in Figur 2 dargestellt. Dort ist der Defokus in mm in Abhängigkeit vom Öffnungswinkel in Grad angegeben, wobei die Fokalfäche an diesen Verlauf angepasst ist.

Das Detektormodul bzw. Zeilenmodul mit dem Detektor 11 und dem flexiblen Trägersubstrat 13 ist schematisch in Figur 3 in einer Draufsicht gezeigt. Auf der Oberfläche 13a des Trägersubstrats sind elektrische Kontakte 16 als Außenanschlüsse für eine elektrische Verbindung zu einer Ansteuer- und Ausleseelektronik ausgestaltet. Die elektrischen Kontakte 16 befinden sich am Rand entlang der Breite des Detektormoduls. Elektrische Verbindungen 17 vom Chip bzw. Detektor 11 zum Trägersubstrat 13 sind über die Chipkante gezogen. Die Kontakte sind somit durch isoplanare Kontaktierung hergestellt, so dass bei der Herstellung keine hohen lokalen Druckkräfte, wie z.B. beim Drahtbonden, auf die extrem dünnen Chips wirken. Die elektrischen Verbindungen 17 sind durch Siebdrucktechnik ausgestaltet.

In der bevorzugten Ausführungsform der Erfindung werden als Detektoren 11 CMOS-APS-Zeilendetektoren verwendet. Es ist aber auch möglich, CCD-Detektoren zu verwenden. Die Detektorzeilen haben beispielsweise 10.240, 8.192, 6.144, 4.096, 2.048 oder 1.024 Pixel. Die Länge der verwendeten Zeilendetektoren bzw. Siliziumbausteine beträgt ca. 100mm, während ihre Breite nur ca. 3mm beträgt, woraus sich das sehr große Längen- zu Breitenverhältnis ergibt. Die Silizium-Elemente bzw. Siliziumscheiben zur Bildung der Detektoren 11 sind auf ca. $25\mu m$ gedünnt bzw. in ihrer Dicke reduziert. Die Dicke des Detektors 11 bzw. des eigentlichen Zeilensensors, der von dem Trägersubstrat 13 unterstützt wird, beträgt ca. $20\mu m$.

Der Zeilensensor bzw. Detektor 11 mit seinen ca. 2.000 bis 10.000 Pixeln hat weiterhin eine lichtdurchlässige Abdeckung, die in Figur 1 nicht dargestellt ist. Dazu ist die entsprechende CMOS-Zeile zwischen zwei Folien einlaminiert, wobei die untere Folie das Trägersubstrat 13 mit den beschriebenen Anschlussstrukturen bildet, während die obere Folie durchsichtig ist und lediglich als Schutz dient. Dadurch wird die weitere Handhabung des Zeilenmoduls bzw. der Detektorzeile auf dem flexiblen Trägersubstrat 13 wesentlich erleichtert und die Bruchempfindlichkeit des gedünnten Siliziumchips, der als Einkristall ausgebildet ist, wird deutlich herabgesetzt.

Figur 4 zeigt ein bekanntes Cassegrain-System als Beispiel für eine Frontoptik, die mit der gekrümmten Fokalfläche gemäß der vorliegenden Erfindung ausgestattet werden kann um ein optoelektronisches Bildaufnahmesystem zu bilden. Beim Cassegrain-System als Frontoptik 20 fallen die Strahlen eines entfernten Objekts auf einen konkaven Spiegel 21 und werden in einen Fokus f1 reflektiert. Bevor die Strahlen konvergieren, reflektiert ein Konvex-Spiegel 22 die Strahlen in einen zweiten Fokus f2 durch eine Zentralöffnung 23 im Spiegel 21. In der klassischen Cassegrain-Form ist der Spiegel 21 ein Paraboloid und der Konvex-Spiegel 22 ein Hyperboloid mit den Foki f1 und f2. Daneben sind auch andere bekannte Ausgestaltungen von Frontoptiken zusammen mit der erfindungsgemäßen, gekrümmten Fokalfläche möglich, wie z.B. das Schmidt-System oder das sogenannte Ritchey-Chrétien System.

Konvergierende Elemente bzw. konkave Spiegel haben allgemein eine starke Petzval-Krümmung, die konvex in Richtung der einfallenden Strahlen ist und in Figur 5 dargestellt ist. Allgemein ergibt sich die Petzval-Krümmung einer reflektierenden Fläche aus der Formel

$$P = 2 \, n \, c \qquad\qquad\qquad (2)$$

wobei n der Brechungsindex des Mediums ist, das in Kontakt mit dem Spiegel steht und $c = 1/r$ der Krümmungsparameter ist.

Figur 6 zeigt als Beispiel den Strahlengang in einem Schmidt-Teleskop mit einem reflektiven Korrektor 24 gemäß dem Stand der Technik. Das Teleskop umfasst weiterhin einen Primärspiegel 24b und einen Faltspiegel 24c. Der reflektive Korrektor 24 dient dazu, eine Abbildung auf eine ebene Fokalfläche bzw. Fokalebene 24a zu ermöglichen. In anderen bekannten Systemen werden z.B. auch transmissive Korrektoren oder Korrektorplatten verwendet, um die Strahlen auf eine ebene Fläche abzubilden, wie sie die bekannte Detektor-Technologie verlangt.

Das Bildaufnahmesystem gemäß der vorliegenden Erfindung umfasst stattdessen eine gekrümmte Fokalfläche, beispielsweise gemäß der oben beschriebenen Ausführungsform, die an eine bekannte Frontoptik 20 gekoppelt ist und an die Krümmung der Strahlen bzw. die Feldkrümmung angepasst ist.

Figur 7 zeigt eine gekrümmte Fokalfläche 50 gemäß einem anderen Ausführungsbeispiel. Der Aufbau des Detektormoduls, bestehend aus dem Detektor 11, dem Trägersubstrat 13 und den beiden Klebeschichten bzw. Verbindungsschichten 12, 14, ist wie bei der oben in bezug auf Figur 1 beschriebenen Ausführungsform ausgestaltet. Im Detektorträger 15 bzw. in der Fokalflächen-Rückplatte befinden sich jedoch Kanäle 51, die als Mikrokanäle bzw. micro heat-pipes ausgestaltet sind. Die Anordnung der Kanäle 51 ist derart, dass die Temperaturverteilung in der Rückplatte bzw. im Detektorträger 15 möglichst gleichförmig ist. Dazu verlaufen die Kanäle 51 in Gegenstromrichtung, d.h. es wird ein Hin- und Rücklauf von Kühlmittel im Detektorträger 15 bzw. in den Kanälen 51 erzielt.

Figur 8 zeigt eine andere Variante der Realisierung eines Temperatur-Kontrollsystems in einer Fokalfläche 60. Dabei sind Peltier-Elemente 61 an die Rückseite des Detektorträgers 15 gekoppelt. Dazu können z.B. 3 bis 10 Peltier-Elemente 61 an der Rückplatte eingebaut sein, so dass eine gleichmäßige Temperaturverteilung gewährleistet ist, auch unter sehr ungleichmäßiger Verteilung der Wärmedissipationen. Diese Anordnung hat den Vorteil, dass die Regelung elektronisch erfolgt, wobei z.B. keine Pumpen erforderlich sind. Auch entfällt die ansonsten notwendige Abfuhr der Wärme an die Umgebung, ebenso wie ein Abdichten von Kühlkreisläufen.

Die Temperaturkontrolle bzw. Temperaturregelung erfolgt über Rechenprogramme unter Berücksichtigung von temperaturabhängigen Stoffwerten. Der weitere Aufbau auf dem Detektorträger 15 ist analog zu den oben unter Bezugnahme auf die Figuren 1 und 7 bereits beschriebenen Aufbauten.

Die Fokalflächen 50 und 60 mit einem Temperaturkontrollsystem gemäß den Figuren 7 und 8 sind z.B. an ein Schmidt-Teleskop als Frontoptik 20 gekoppelt. Aufgrund der hohen Flexibilität der Detektoren 11 ist es ebenso möglich, die gekrümmten Detektorzeilen mit einem variablen bzw. einstellbaren Krümmungsradius zu versehen.

Das Temperaturkontrollsystem ist so ausgelegt, dass alle Pixel des Zeilensensors in gekrümmter Aufbautechnik auch unter extremen äußeren Bedingungen, wie z.B. extreme Umgebungstemperaturen oder extremer Lichteinfall über die Zeile, innerhalb eines definierten Temperaturbereichs gehalten werden. Als Materialien, beispielsweise für die Verbindungsschichten 12 und 14, können flexible pyrolitische Grafit-Folien mit Wärmeleitzahlen bis zu 600 bis 800W/mK bei 0,1mm Dicke und einer Dichte von 1g/cm$^3$ verwendet werden. Weiterhin können zum Detektoraufbau auch verkapselte Folien verwendet werden, die innen ein TPG-Material (thermal pyrolitic graphite) mit einer sehr hohen Wärmeleitzahl von 1200W/mK, und außen verschiedene mögliche Materialien wie Kupfer, Aluminium, Kohlefaser oder Al-SiC aufweisen.

Im folgenden wird ein erfindungsgemäßes Verfahren zur Herstellung von Detektoren bzw. dünnen Zeilendetektoren und einer gekrümmten Fokalfläche 10, 50, 60 anhand der Figuren 9a bis g beschrieben.

Zunächst werden Siliziumbausteine bzw. Chips mit einer Länge von ca. 100mm und einer Breite von ca. 3mm bereitgestellt. Nun werden die fertig prozessierten Si-Scheiben auf eine Dicke in der Größenordnung von 25µm gedünnt, d.h. in ihrer Dicke reduziert. Dazu wird ein zu dünnender Wafer bzw. ein Silizium-Element 71 mit einem Hilfsträger 72 verbunden. Bei der Verbindung ist die aktive Seite 71a des Si-Elements 71 dem Hilfsträger 72 zugewandt (Fig. 9a). Der Hilfsträger 72 kann ein Silizium oder Glaswafer sein. Als Zwischenschicht 73 zwischen dem Silizium-Element 71 und dem Hilfsträger 72 wird ein flüssig aufgebrachter Kleber oder eine Klebefolie verwendet. Dabei wird streng darauf geachtet, dass die Verbindung keine Lunker enthält. Der nun folgende Dünnungsprozess ist auf die Topographie der zu dünnenden Scheiben abgestimmt. Da die Zeilendetektoren sehr lang sind, z.B. 100mm, wird bei der Entwicklung des Dünnungsprozesses besonderer Augenmerk auf die Dickenvariation und einen möglichen Keilfehler gelegt. Beide sollten jeweils ≦1 bis 2µm sein.

Das eigentliche Dünnen der ca. 700µm dicken Wafer erfolgt in einem mehrstufigen Prozess von Schleifen über Spin-Ätzen bis zum chemisch-mechanischen Polieren (CMP). Schleifen hat dabei eine sehr hohe Abtragsrate, die z.B. 100 bis 200µm/min beträgt. Dabei können jedoch unter Umständen Fehlstellen in der Kristalloberfläche des Siliziums erzeugt werden. Beim Spin-Ätzen mit einer mittleren Abtragungsrate von 20 bis 50µm/min wird dies vermieden, jedoch erhält man zumeist eine leichte Welligkeit. CMP hingegen hat eine sehr geringe Abtragungsrate im Bereich von 1 bis 2µm/min, liefert dafür aber die höchste Präzision. Der Dünnungsablauf wird unter Verwendung des jeweils geeignetsten Prozesses so ausgestaltet, dass mit vertretbarem Zeitaufwand die geforderten Spezifikation eingehalten werden.

Der Hilfsträger 72 wird bis zum Aufsetzen des Zeilendetektors auf das Trägersubstrat 13 (Figur 9b) beibehalten. Dies hat den Vorteil einer leichteren Handhabung. Das Silizium-Element 71 ist mit seiner aktiven Seite 71a mit dem Hilfsträger 72 in Kontakt. Das Silizium-Element 71 beziehungsweise der Wafer wird auf eine Dicke von weniger als 50µm gedünnt.

Das Vereinzeln der dünnen Wafer in Chips kann entweder vor dem Dünnen oder nach dem Dünnen erfolgen. Im vorliegenden Fall wird zum Vereinzeln nicht der Standardprozess des Sägens verwendet, da bei dem gedünnten Wafern ansonsten die Gefahr besteht, dass die Chipkanten Ausbrüche zeigen. Durch die Kerbwirkung kann es unter bestimmten Voraussetzungen zum Chipbruch kommen, was im vorliegenden Fall wegen des großen Längen- zu Breitenverhältnisses von ca. 40 besonders kritisch ist. Hier wird deshalb bevorzugt ein Verfahren zum Vereinzeln durchgeführt, das zu sauberen, unbeschädigten Chipkanten führt und eine hohe Ausbeute an CMOS-Detektorzeilen pro Wafer erlaubt.

Beim Vereinzeln vor dem Dünnen werden die einzelnen Chips durch Gräben im noch ungedünnten Wafer getrennt, wobei die Tiefe der Gräben der angestrebten Restdicke von ca. 25µm entspricht. Zur Herstellung der Gräben, kommen Ätzverfahren, die senkrechte Wände im Silizium erzeugen, oder das Einsägen in Betracht. In beiden Fällen ist als kritischer Punkt die Unterätzung zu betrachten, welche die Bondpads angreift. Sie tritt während des Spin-Ätzens oder CMP beim Dünnungsprozess ein, sobald die Gräben offen liegen.

Obwohl das Ätzverfahren aufwendiger ist und zudem eine Ätzmaske und Lithografieschritte benötigt werden, hat es den Vorteil einer genaueren und gleichmäßigeren Definition der Grabentiefe. Kantenausbrüche, die beim Einsägen vor dem Dünnen entstehen, können beim Dünnungsprozess noch ausgeheilt werden.

Für das Vereinzeln nach dem Dünnen kommen vor allem Verfahren in Betracht, die saubere Chipkanten zulassen, wie z.B. das Ätzen. Ein Problem ist hierbei die Erkennung der Sägestrassen, da der gedünnte Wafer mit seiner aktiven Seite 71 a zum Träger bzw.Hilfsträger 72 zeigt. Zur Lösung bietet sich an, Maskaligner mit IR-Justierung zu verwenden, einen Hilfsträger 72 aus Glas zu verwenden und die Zwischenschicht 73 durchsichtig zu gestalten (Doppelseiten-Maskaligner), oder das Einbringen von Justiermarken vor dem Dünnen. Auch kann das Vereinzeln durch Laserschneiden erfolgen, als Alternative zum Ätzen.

Für die weitere Montage der gedünnten Chips auf Substrate bzw. das Trägersubstrat 13 ist der Trägerwafer in einem Standart-Sägeprozess zu zerteilen.

Figur 9a zeigt den Hilfsträger 72 mit der darauf befindlichen Verbindungs- oder Zwischenschicht 73 und den zu dünnenden Wafer bzw. Silizium-Element 71. Das Silizium-Element 71 ist mit seiner aktiven Seite 71a dem Hilfsträger 72 zugewandt. In diesem Verbund erfolgt das Dünnen des Silizium-Elements 71, wie es oben beschrieben ist.

Nun werden die dünnen CMOS-Zeilendetektoren bzw. Silizium-Elemente 71 mit dem Hilfsträger 72 auf flexiblen Substraten 13 montiert. Figur 9b zeigt den auf dem Trägersubstrat 13 befestigten Verbund aus dem Hilfsträger 72, der Verbindungs- bzw. Zwischenschicht 73 und dem Zeilendetektor bzw. Detektor. Dieser Verbund ist mittels einer Klebeschicht bzw. Verbindungsschicht 12 (siehe auch Figur 1) mit dem Trägersubstrat 13 verbunden.

Bei der Montage der dünnen Chips wird ein gleichmäßig dünner, reproduzierbarer Kleberauftrag durchgeführt und anschließend wird das lange Chip auf das Trägersubstrat 13 planparallel aufgesetzt. Es wird dabei eine gleichmäßig dünne Verbindungsfuge mit einer Dicke von weniger als 10$\mu$m, bevorzugt ca. 1 bis 2$\mu$m, geschaffen, die stressarm ist.

Nun wird der Hilfsträger 72 bzw. das Trägerchip einschließlich der Verbindungs- bzw. Zwischenschicht 73 rückstandsfrei entfernt. Dabei wird darauf geachtet, dass keine Rückstände verbleiben und keine chemische Reaktion mit der Padmetallisierung stattfindet.

Als Trägersubstrate 13 werden flexible Folien verwendet, die später das Einbringen in eine gekrümmte Fläche einer FP-Rückplatte bzw. Fokalflächen-Rückplatte gestatten.

Als Alternative zum Aufbau über eine flexible Folie als Zwischenträger kann in bestimmten Fällen der Zeilendetektor auch direkt, d.h. ohne Hilfsträger, auf dem FPA-Träger bzw. Fokalflächenträger montiert werden.

Das Trägersubstrat 13 mit dem darauf befindlichen Zeilendetektor 11 und seinen elektrischen Kontakten 16a ist schematisch in Figur 9c als Schnittansicht dargestellt. Der Hilfsträger 72 (Figur 9b) ist bereits entfernt.

Im nächsten Schritt erfolgt das Anbringen der Kontakte. Dabei wird eine isoplanare Kontaktierung durchgeführt. Dies hat gegenüber dem ansonsten in der Mikroelektronik üblichen Drahtbonden den Vorteil, dass keine hohen lokalen Druckkräfte eines Bondstempels zur Zerstörung der extrem dünnen Chips führen können.

Bei der isoplanaren Kontaktierung werden die elektrischen Verbindungen vom Chip bzw. Chipanschlüssen oder Kontakten 16a zum Substrat über die Chipkante gezogen. Die Figuren 9d und 9e zeigen ein Schema für die isoplanare Kontaktierung des Detektors 11 in einer Schnittansicht und in einer Draufsicht. Die Detektorzeile bzw. der Detektor 11 ist durch die Verbindungsschicht 12, die ein Kleber ist, auf dem Trägersubstrat 13, das eine Substratfolie ist, befestigt. In einem Randbereich des Trägersubstrats 13 befinden sich die elektrischen Kontakte 16 bzw. Außenanschlüsse. Elektrische Verbindungen 17 führen vom Chip zum Substrat über die Chipkante (s. auch Fig. 3).

Die Herstellung der elektrischen Verbindungen 17 kann z.B. durch Siebdrucktechnik erfolgen.

In einem optional möglichen Testverfahren werden Substrate und Wafer entworfen und hergestellt, die passive Teststrukturen wie z.B. Kelvin- oder Daisy-Chain-Strukturen enthalten. Dabei werden die Kontakte unter Variation und Optimierung leitfähiger Pasten gedruckt. Anschließend wird der Kontaktwiderstand im Hinblick auf einen zuverlässigen Kontakt vom CMOS-Zeilendetektor zum Substrat untersucht. Weiterhin wird der Einfluss der Chipkante im Hinblick auf den Isolationswiderstand, die Bedruckbarkeit, eine Unterbrechung der Leiterbahnen in Folge von Temperatureinflüssen, usw. untersucht.

Nun wird der Detektor 11 mit den damit verbundenen Strukturen mit einer lichtdurchlässigen Abdeckung 74 versehen. Dazu wird die CMOS-Zeile zwischen zwei Folien einlaminiert. Die Figuren 9f und 9g zeigen den Detektor 11 mit dem darunterliegenden Trägersubstrat 13 und der lichtdurchlässigen Abdeckung 74, die auf der Oberseite des Detektors 11 angeordnet ist. Das Trägersubstrat 13 wird durch eine untere Folie oder Trägerfolie gebildet, an der sich die Anschlussstrukturen befinden. Die Abdeckung 74 ist eine obere Folie, die durchsichtig ist und als Schutz dient. Dadurch wird die weitere Handhabung des Zeilenmoduls, das aus der Detektorzeile bzw. dem Detektor 11 auf dem flexiblen Substrat 13 gebildet ist, wesentlich erleichtert. Die elektrischen Verbindungen 17 und Außenanschlüsse bzw. elektrischen Kontakte 16 wurden oben bereits beschrieben.

Figur 10 zeigt eine Anordnung zur Ausbildung unterschiedlicher Krümmungsradien in einem nach dem obigen Verfahren hergestellten Detektor 11 bzw. Detektorelement für optoelektronische Bildaufnahmesysteme. Dabei wird das Detektormodul, bestehend aus dem Detektor 11, der Verbindungsschicht 12 und dem Trägersubstrat 13, von der Rückseite in seinen Randbereichen durch Auflageelemente 75 unterstützt, während von der gegenüberliegenden Seite eine Kraft F im wesentlichen im Zentrum des Detektors 11 durch einen Aktuator aufgebracht wird. Auch ist es beispielsweise möglich, den Detektorträger 15 (Figur 1) mit Mitteln bzw. Aktuatoren zur Veränderung der Krümmung seiner Oberfläche 15a zu versehen. Der flexible Detektor 11 gemäß der vorliegenden Erfindung ist an die unterschiedlichen Krümmungen anpassbar und somit ist die gesamte Fokalfläche 10 mit dem Detektor 11 entsprechend den jeweiligen Anforderungen der Optik und der Umgebungsbedingungen anpassbar.

In Figur 10 ist die Anordnung als Testaufbau zum Test gekrümmter bzw. biegbarer Detektoren 11 ausgestaltet. Beim Test werden die Signale aus dem Schieberegister des Detektors 11 ausgelesen, die Funktionsfähigkeit der Zeilenmodule überprüft und auf mögliche Fehler untersucht, während der Krümmungsradius des Zeilenmoduls variiert wird.

Nach dem optionalen Test wird das Zeilenmodul, d.h. der auf dem Trägersubstrat 13 montierte Detektor 11 in den Fokalflächen- bzw. Detektorträger 15 eingebracht. Dabei muss das Zeilenmodul möglichst passgenau montiert werden. Das auf dem Detektorträger 15 montierte Zeilen- oder Detektormodul ist in Figur 1 dargestellt und wurde oben bereits beschrieben. Bei der Einpassung des Detektormoduls und seiner Anpassung an die Krümmung des Detektorträgers 15 werden die jeweiligen Anforderungen wie laterale und vertikale Toleranzen, Zuverlässigkeit im Hinblick auf Temperatur und Beschleunigung usw., Lichtbeständigkeit, u.ä. eingehalten. Bei der Einhaltung des Krümmungsradius sind, wie oben gezeigt, als Toleranzen Abweichungen von ca. $30\mu m$ zulässig. Diese Toleranzen können gut eingehalten werden, da sich die einzelnen Dicken der verschiedenen Schichten des Zeilenmoduls im $\mu m$-Bereich bewegen (Detektorzeile ca. $20\mu m$, Substratfolie bzw. Trägersubstrat 13 ca. 50 bis $100\mu m$, Kleberschicht $< 10\mu m$).

Nach dem Einbringen des Zeilenmoduls in den Detektorträger 15 werden die elektrischen Verbindungen zur Ansteuer- und Ausleseelektronik hergestellt. Dafür ist eine zuverlässige mechanische und elektrische Befestigung des Verbindungselements auf dem Zeilenmodul vorgesehen.

Durch entsprechende Tests wird ein derartiges, komplettes FPA-Modul, d.h. ein mit dem Detektorträger 15 verbundenes Detektormodul, auf seine Funktionsfähigkeit geprüft. Durch Variation der Testparameter wird die Zuverlässigkeit schrittweise erhöht. Dabei werden vor allen Dingen im Bereich der Raumfahrt auftretende Bedingungen wie Vibrationen, Beschleunigungen, Temperatur, Temperaturgradienten, Temperaturwechsel, Feuchte, Bestrahlung bzw. Lichteinwirkung usw. berücksichtigt. Entsprechend den jeweiligen Anforderungen und Betriebsbedingungen werden die Module schrittweise optimiert.

Durch die Erfindung und insbesondere durch die erfindungsgemäße Aufbautechnik gekrümmter Fokalflächen werden optische Instrumente, insbesondere Weltrauminstrumente mit weitem Sehfeld und weiten Brennweiten vereinfacht. Auch in anderen Anwendungsgebieten kann die Frontoptik eines optischen Systems wesentlich einfacher ausgelegt werden, da aufgrund der Erfindung die Forderung nach einer ebenen Abbildung auf die Halbleiterdetektoren umgangen werden kann.

Feldkorrektoren können vermieden werden, was neuartige Teleskopkonzepte erlaubt, ebenso wie Instrumentenkonzepte mit einer aktiven oder adaptiven Regelung der Form der Fokalebene, die anstelle oder auch in Kombination mit den bisher eingesetzten aktiven oder adaptiven Optiken eingesetzt werden kann.

Frontoptiken wie Teleskope oder Objektive lassen sich einfacher realisieren, insbesondere bei weiten Sehfeldern mit Spiegelteleskopen. Ein erfindungsgemäßes Bildaufnahmesystem mit der hier beschriebenen Fokalfläche hat eine geringere thermo-mechanische Empfindlichkeit bzw. eine höhere Robustheit als herkömmliche Systeme. Es ergeben sich geringere Transmissionsverluste und ein sehr breitbandiger spektraler Übertragungsbereich. Aktive bzw. adaptive Regelungen der Teleskopoptiken können ergänzt werden durch Verfahren, bei denen z.B. die Position der Detektoren in der optischen Einfallsrichtung verändert wird. Weiterhin ergeben sich kostengünstigere Bildaufnahmesysteme, da die Optik bei einem größeren Sehfeld und reduzierten Verzerrungen wesentlich vereinfacht werden kann.

**Bezugszeichen**

| | |
|---|---|
| 10 | Fokalfläche |
| 11 | Detektor |
| 11a | Oberfläche des Detektors |
| 12 | 1. Verbindungsschicht |
| 13 | Trägersubstrat |
| 13a | Oberfläche des Trägersubstrats |
| 14 | 2. Verbindungsschicht |
| 15 | Detektorträger |
| 15a | Oberfläche des Detektorträgers |
| 16 | elektrische Kontakte |
| 16a | elektrische Kontakte |
| 17 | elektrische Verbindungen |
| 20 | Frontoptik |
| 21 | Konkaver Spiegel |
| 22 | Konvex-Spiegel |
| 23 | Zentralöffnung |
| 24 | Korrektor (SdT) |
| 24a | ebene Fokalfläche (SdT) |
| 24b | Primärspiegel |

| 24c | Faltspiegel |
|---|---|
| 50 | Fokalfläche |
| 51 | Kanäle |
| 60 | Fokalfläche |
| 61 | Peltierelemente |
| 71 | Si-Elemente |
| 71a | aktive Seite des Si-Elements |
| 72 | Hilfsträger |
| 73 | Zwischenschicht |
| 74 | lichtdurchlässige Abdeckung |
| 75 | Auflageelement |
| F | Kraft |
| $f_1$ | Fokus |
| $f_2$ | Fokus |

**Patentansprüche**

1. Vorrichtung für optoelektronische Bildaufnahmesysteme, mit einer Anordnung von Detektoren (11) zur Bildaufnahme, und einem Detektorträger (15) zum Halten der Detektoren (11), wobei die Detektoren (11) jeweils aus mindestens einem Silizium-Element (71) hergestellt sind und wobei die Detektoren (11) eine Krümmung zur Aufnahme eines gekrümmten Bildfelds aufweisen und wobei die Detektoren (11) flexibel ausgestaltet sind, und wobei das Silizium-Element (71) gedünnt ist und mit einem flexiblen Trägersubstrat (13) verbunden ist **gekennzeichnet durch** ein Temperatur-Kontrollsystem (51; 61), welches so ausgelegt ist, dass die Temperaturverteilung im Detektorträger (15) möglichst gleichmäßig ist, wobei das Temperatur-Kontrollsystem (51, 61) Kanäle (51) im Detektorträger (15) aufweist, welche in Gegenstromrichtung verlaufen.

2. Vorrichtung für optoelektronische Bildaufnahmesysteme, mit einer Anordnung von Detektoren (11) zur Bildaufnahme, und einem Detektorträger (15) zum Halten der Detektoren (11), wobei die Detektoren (11) jeweils aus mindestens einem Silizium-Element (71) hergestellt sind und wobei die Detektoren (11) eine Krümmung zur Aufnahme eines gekrümmten Bildfelds aufweisen und wobei die Detektoren (11) flexibel ausgestaltet sind, und wobei das Silizium-Element (71) gedünnt ist und mit einem flexiblen Trägersubstrat (13) verbunden ist **gekennzeichnet durch** ein Temperatur-Kontrollsystem (51; 61), welches so ausgelegt ist, dass die Temperaturverteilung im Detektorträger (15) möglichst gleichmäßig ist, wobei der Detektorträger (15) an Peltierelemente (61) gekoppelt ist.

3. Vorrichtung nach Anspruch 1, **dadurch gekennzeichnet, dass** der Detektorträger (15) an Peltierelemente (61) gekoppelt ist.

4. Vorrichtung nach einem der Ansprüche 1 bis 3, **dadurch gekennzeichnet, dass** die Detektoren (11) gedünnt sind und gekrümmt in einer Fokalfläche (10; 50; 60) angeordnet sind.

5. Vorrichtung nach einem der Ansprüche 1 bis 4, **dadurch gekennzeichnet, dass** die Detektoren (11) mittels eines Hilfsträgers (72) hergestellt sind, der zum Dünnen des mindestens einen Silizium-Elements (71) mit dem Silizium-Element (71) verbunden ist und nach dem Dünnen entfernbar ist.

6. Vorrichtung nach einem der Ansprüche 1 bis 5, **dadurch gekennzeichnet, dass** das Silizium-Element (71) eine Dicke im Bereich von weniger als 50 $\mu$m, bevorzugt im Bereich von weniger als 20 $\mu$m, insbesondere der Bereich von ca. 10 bis 20 $\mu$m.

7. Vorrichtung nach einem der Ansprüche 1 bis 6, **dadurch gekennzeichnet, dass** die Detektoren (11) CMOS-Zeilendetektoren sind.

8. Vorrichtung nach einem der Ansprüche 1 bis 7, **gekennzeichnet durch** eine Aktorik zur variablen Krümmung der Detektoren (11)

9. Vorrichtung nach einem der Ansprüche 4 bis 7, **gekennzeichnet durch** eine Aktorik zur variablen Krümmung der Fokalfläche (10; 50; 60).

**10.** Verfahren zur Herstellung einer Fokalfläche für optoelektronische Bildaufnahmesysteme, bei dem ein gekrümmter Detektorträger (15) mit einer Detektor-Anordnung (11) zur Bildaufnahme versehen wird, **dadurch gekennzeichnet, dass** zur Ausgestaltung flexibler Detektoren (11) jeweils mindestens ein Silizium-Element (71) gedünnt und mit einem flexiblen Trägersubstrat (13) verbunden wird, wobei die flexiblen Detektoren (11) an die Krümmung des Detektorträgers (15) angepasst werden oder anpassbar sind und ferner ein Temperatur-Kontrollsystem (51; 61)im Detektorträger (15) eingebracht wird, welches die Temperaturverteilung im Detektorträger (15) möglichst gleichmäßig hält.

**11.** Verfahren nach Anspruch 10, **dadurch gekennzeichnet, dass** das Silizium-Element (71) zum Dünnen mit einem Hilfsträger (72) verbunden wird.

**12.** Verfahren nach Ansprüche 10 oder 11, **dadurch gekennzeichnet, dass** das Silizium-Element (71) zum Dünnen mit einem Hilfsträger (72) verbunden wird, wobei der Hilfsträger (72) nach dem Dünnen entfernt wird oder entfernbar ist.

**13.** Verfahren nach einem der Ansprüche 10 bis 12, **dadurch gekennzeichnet, dass** das Dünnen durch Abtragen mittels Schleifen, Ätzen, Spin-Ätzen, chemisch-mechanisches Polieren oder eine Kombination davon erfolgt.

**14.** Verfahren nach einem der Ansprüche 10 bis 13, **dadurch gekennzeichnet, dass** das Silizium-Element (71) zunächst als Wafer vorliegt und vor dem Verbinden mit dem Trägersubstrat (13) in Chips vereinzelt wird.

**15.** Verfahren nach einem der Ansprüche 10 bis 14, **dadurch gekennzeichnet, dass** das Silizium-Element (71) durch isoplanare Kontaktierung mit elektrischen Kontakten (16, 16a) versehen wird.

**16.** Verfahren nach einem der Ansprüche 10 bis 15, **dadurch gekennzeichnet, dass** das Silizium-Element (71) mit einer lichtdurchlässigen Abdeckung (74) versehen wird.

**Claims**

**1.** An apparatus for optoelectronic image-recording systems, with an array of detectors (11) for image-recording, and with a detector support (15) for holding the detectors (11), wherein the detectors (11) have each been produced from at least one silicon element (71), and wherein the detectors (11) exhibit a curvature for the purpose of recording a curved image field, and wherein the detectors (11) are configured flexibly, and wherein the silicon element (71) is thinned and connected to a flexible supporting substrate (13), **characterised by** a temperature-control system (51; 61) which is designed in such a way that the temperature distribution in the detector support (15) is as uniform as possible, the temperature-control system (51, 61) exhibiting channels (51) in the detector support (15) which extend in the counterflow direction.

**2.** An apparatus for optoelectronic image-recording systems, with an array of detectors (11) for image-recording, and with a detector support (15) for holding the detectors (11), wherein the detectors (11) have each been produced from at least one silicon element (71), and wherein the detectors (11) exhibit a curvature for the purpose of recording a curved image field, and wherein the detectors (11) are configured flexibly, and wherein the silicon element (71) is thinned and connected to a flexible supporting substrate (13), **characterised by** a temperature-control system (51; 61) which is designed in such a way that the temperature distribution in the detector support (15) is as uniform as possible, the detector support (15) being coupled to Peltier elements (61).

**3.** An apparatus according to Claim 1, **characterised in that** the detector support (15) is coupled to Peltier elements (61).

**4.** An apparatus according to one of Claims 1 to 3, **characterised in that** the detectors (11) are thinned and arranged in curved manner in a focal surface (10; 50; 60).

**5.** An apparatus according to one of Claims 1 to 4, **characterised in that** the detectors (11) have been produced by means of an auxiliary support (72) which for the purpose of thinning the at least one silicon element (71) is connected to the silicon element (71) and is capable of being removed after the thinning.

**6.** An apparatus according to one of Claims 1 to 5, **characterised in that** the silicon element (71) exhibits a thickness within the range of less than 50 μm, preferably within the range of less than 20 μm, in particular within the range from about 10 μm to 20 μm.

7. An apparatus according to one of Claims 1 to 6, **characterised in that** the detectors (11) are CMOS linescan detectors.

8. An apparatus according to one of Claims 1 to 7, **characterised by** an actuator system for the purpose of variable curvature of the detectors (11).

9. An apparatus according to one of Claims 4 to 7, **characterised by** an actuator system for the purpose of variable curvature of the focal surface (10; 50; 60).

10. A process for producing a focal surface for optoelectronic image-recording systems, wherein a curved detector support (15) is provided with a detector array (11) for image-recording, **characterised in that** for the purpose of configuring flexible detectors (11) in each instance at least one silicon element (71) is thinned and connected to a flexible supporting substrate (13), the flexible detectors (11) being adapted, or capable of being adapted, to the curvature of the detector support (15) and furthermore a temperature-control system (51; 61) in the detector support (15) being introduced which keeps the temperature distribution in the detector support (15) as uniform as possible.

11. A process according to Claim 10, **characterised in that** the silicon element (71) is connected to an auxiliary support (72) for the purpose of thinning.

12. A process according to Claim 10 or 11, **characterised in that** the silicon element (71) is connected to an auxiliary support (72) for the purpose of thinning, the auxiliary support (72) being removed, or capable of being removed, after the thinning.

13. A process according to one of Claims 10 to 12, **characterised in that** the thinning is effected by abrading by means of grinding, etching, spin etching, chemical-mechanical polishing or a combination thereof.

14. A process according to one of Claims 10 to 13, **characterised in that** the silicon element (71) is present to begin with in the form of a wafer and is separated into chips prior to being connected to the supporting substrate (13).

15. A process according to one of Claims 10 to 14, **characterised in that** the silicon element (71) is provided with electrical contacts (16, 16a) by isoplanar contacting.

16. A process according to one of Claims 10 to 15, **characterised in that** the silicon element (71) is provided with a light-transmitting cover (74).

**Revendications**

1. Dispositif pour des systèmes d'imagerie optoélectronique comportant un montage de détecteurs (11) pour la prise de vue et un support de détecteur (15) pour tenir les détecteurs (11),
les détecteurs (11) étant formés d'au moins un élément en silicium (71) et ils ont une courbure pour prendre un champ cintré et sont souples, l'élément de silicium (71) étant aminci et relié à un support de substrat souple (13) **caractérisé par**
un système de contrôle de température (51, 61) conçu pour que la distribution de température dans le support de détecteur (15) soit aussi régulière que possible,
le système de contrôle de température (51, 61) ayant des canaux (51) dans le support de détecteur (15) qui correspondent à un passage à contre-courant.

2. Dispositif pour des systèmes d'imagerie optoélectronique comportant un montage de détecteurs (11) pour la prise de vue et un support de détecteur (15) pour tenir les détecteurs (11),
les détecteurs (11) étant réalisés chacun par au moins un élément en silicium (71) et
les détecteurs (11) ayant une courbure pour prendre un champ d'image courbe et
les détecteurs étant souples, l'élément de silicium (71) étant aminci et relié à un support de substrat (13) souple, **caractérisé par**
un système de contrôle de température (51, 61) conçu pour que la distribution de température dans le support de détecteur (15) soit aussi régulière que possible et le support de détecteur (15) est couplé à des éléments à effet Peltier (61).

**3.** Dispositif selon la revendication 1,
**caractérisé en ce que**
le support de détecteur (15) est couplé à des éléments à effet Peltier (61).

**4.** Dispositif selon l'une des revendications 1 à 3,
**caractérisé en ce que**
les détecteurs (11) sont amincis et cintrés dans une surface focale (10, 50, 60).

**5.** Dispositif selon l'une des revendications 1 à 4,
**caractérisé en ce que**
les détecteurs (11) sont réalisés à l'aide d'un support auxiliaire (72) relié à l'élément de silicium (71) pour amincir au moins cet élément de silicium (71) et ce support est enlevé une fois l'amincissement réalisé.

**6.** Dispositif selon l'une des revendications 1 à 5,
**caractérisé en ce que**
l'élément de silicium (71) a une épaisseur inférieure à 50 $\mu$m et de préférence inférieure à 20 $\mu$m et notamment de l'ordre de 10 à 20 $\mu$m.

**7.** Dispositif selon l'une des revendications 1 à 6,
**caractérisé en ce que**
les détecteurs (11) sont des détecteurs en ligne, en technique CMOS.

**8.** Dispositif selon l'une des revendications 1 à 7,
**caractérisé par**
des actionneurs pour cintrer les détecteurs (11) de façon variable.

**9.** Dispositif selon l'une des revendications 4 à 7,
**caractérisé par**
des actionneurs pour cintrer de manière variable la surface focale (10, 50, 60).

**10.** Procédé de fabrication d'une surface focale pour des systèmes d'imagerie optoélectronique selon lequel on munit un support de détecteur (15) courbe d'un montage de détecteurs (11) pour une prise de vue,
**caractérisé en ce que**
pour réaliser des détecteurs souples (11) on amincit au moins un élément en silicium (71) et on le relie à un substrat de support souple (13), les détecteurs souples (11) étant ou pouvant être adaptés à la courbure du support de détecteur (15), et en outre un système de contrôle de température (51, 61) est installé dans le support de détecteur (15) pour maintenir aussi régulière que possible la distribution de température dans le support de détecteur (15).

**11.** Procédé selon la revendication 10,
**caractérisé en ce que**
l'élément en silicium (71) est relié à un support auxiliaire (72) pour être aminci.

**12.** Procédé selon la revendication 10 ou 11,
**caractérisé en ce que**
l'élément en silicium (71) est relié à un support auxiliaire (72) pour être aminci et une fois l'amincissement réalisé, on enlève le support auxiliaire (72).

**13.** Procédé selon l'une des revendications 10 à 12,
**caractérisé en ce qu'**
on amincit par enlèvement de matière par meulage, gravure, gravure spin, polissage chimique-mécanique ou une combinaison de tels procédés.

**14.** Procédé selon l'une des revendications 10 à 13,
**caractérisé en ce que**
l'élément en silicium (71) est d'abord disponible comme plaquette et il est séparé en puces pour être relié au substrat de support (13).

**15.** Procédé selon l'une des revendications 10 à 14,
**caractérisé en ce que**
l'élément de silicium (71) est muni de contacts électriques (16, 16a) par un contact isoplanaire.

**16.** Procédé selon l'une des revendications 10 à 15,
**caractérisé en ce que**
l'élément de silicium (71) est muni d'un revêtement transparent à la lumière (74).

10

Fig. 1

Öffnungswinkel [Grad]

Fig. 2

Fig. 3

_20_

Fig. 4

SdT

SdT

Fig. 5

SdT

24a

24c

24

24b

Fig. 6

_50_

Fig. 7

_60_

Fig. 8

*71*

*73* — *71a*

*Fig. 9a*

*72*

*73* *72* *Fig. 9b*

*71* *71a*
*12*
*13*

*16a* *16a* *11*
*12*
*13*

*Fig. 9c*

*16a* *72*
*11* *Fig. 9d*
*13*

*11* *16*
*16*
*Fig. 9e*
*13* *17*

Fig. 9f

Fig. 9g

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9802921 A
- US 4825062 A